# EUROPEAN PATENT SPECIFICATION

(11) **EP 0 545 815 B1**
(45) Date of publication and mention of the grant of the patent: **19.03.1997**
(21) Application number: 92403257.6
(22) Date of filing: 02.12.1992
(51) Int. Cl.: H01L 39/22, H01L 39/24

(54) **Josephson junction device formed of oxide superconductor material and process for preparing the same**
Vorrichtung mit Josephson-Übergang aus supraleitendem Oxyd und Verfahren zu seiner Herstellung
Dispositif à jonction Josephson en oxyde supraconducteur et procédé pour sa fabrication

(30) Priority: 02.12.1991 JP 343938/91; 02.12.1991 JP 343939/91; 13.11.1992 JP 328918/92
(43) Date of publication of application: 09.06.1993
(73) Proprietor: Sumitomo Electric Industries, Ltd., Osaka 541 (JP)
(72) Inventor: Nakamura, Takao, F-75116 Paris (FR); Iiyama, Michitomo, F-75116 Paris (FR)
(74) Representative: Ballot, Paul Denis Jacques

(56) References cited:
- EP-A- 0 524 862
- APPLIED PHYSICS LETTERS vol. 56, no. 7, 12 February 1990, NEW YORK, US pages 686 - 688 Laibowitz R.B. et al 'All high Tc edge junctions and SQUID'
- PHYSICA C vol. 171, no. 1&2, 15 October 1990, AMSTERDAM, NL pages 126 - 130 Gao J. et al 'Controlled preparation of all high- Tc SNS-type edge junctions and DC SQUIDs'
- SUPERCONDUCTOR SCIENCE AND TECHNOLOGY vol. 4, no. 9, September 1991, BRISTOL, GB pages 482 - 484 Daginnus M. et al 'Investigation of step-edge microbridges for application as microwave detectors'
- APPLIED PHYSICS LETTERS vol. 59, no. 6, 5 August 1991, NEW YORK, US pages 733 - 735 K.Char et al 'Bi-epitaxial grain boundary junctions in YBa2Cu3O7'
- PHYSICAL REVIEW LETTERS vol. 67, no. 21, 18 November 1991, NEW YORK, US pages 3038 - 3041 Polturak E. et al 'Proximity Effect in YBa2Cu3O7/Y0.6Pr0.4Ba2Cu3O7/ YBa2Cu3O7 Junctions'
- PROCEEDINGS OF THE 4TH INTERNATIONAL CONFERENCE ON SUPERCONDUCTING DEVICES AND THEIR APPLICATIONS, 18-21 June 1991, pages 133-137, Berlin, G; Schilling M. et al: "Multilayer YBa2Cu3Ox Structure- An Approach to SQUID Applications"

## Description

### Background of the Invention

### Field of the invention

The present invention relates to a Josephson junction device formed of oxide superconductor material and a process for preparing the Josephson junction device, and more specifically to a Josephson junction device of an oxide superconductor, of which a barrier of the weak link is constituted of a grain boundary and a process for preparing the Josephson junction device.

### Description of related art

A Josephson junction device which is one of superconducting devices can be realized in various structures. Among the various structures, the most preferable structure in practice is a stacked junction realized by a thin non-superconductor layer sandwiched between a pair of superconductors. However, a point contact type junction, a Dayem bridge type junction and a variable thickness bridge type junction which are composed of a pair of superconductor regions which are weakly linked to each other also exhibit Josephson effect. In general, these Josephson junctions have fine structures in which the superconductor and/or non-superconductor are composed of thin films.

In order to realize a stacked type junction by using an oxide superconductor, a first oxide superconductor thin film, a non-superconductor thin film and a second oxide superconductor thin film are stacked on a substrate in the named order.

In the above mentioned stacked type junction, an insulator MgO etc., a semiconductor Si etc., and a metal Au etc. are used for the non-superconductor layers so that each superconducting junction has different properties for each application.

The thickness of the non-superconductor layer of the stacked type junction is determined by the coherence length of the superconductor. In general, the thickness of the non-superconductor layer of the stacked type junction must be within a few times of the coherence length of the superconductor. On the other hand, since oxide superconductor materials have a very short coherence length, therefore, a thickness of a non-superconductor layer must be about a few nanometers.

However, the superconductor layers and the non-superconductor layer of the stacked type junction must be of high crystallinity for favorable junction properties, which are composed of single crystals or composed of polycrystals which are orientated in almost same direction. It is difficult to stack an extremely thin and high crystalline non-superconductor layer on an oxide superconductor layer. Additionally, it is very difficult to stack a high crystalline oxide superconductor layer on the non-superconductor layer stacked on an oxide superconductor layer. Though the stacked structure including a first oxide superconductor layer, a non-superconductor layer and a second oxide superconductor layer is realized, the interfaces between the oxide superconductor layers and the non-superconductor layer are not in good condition so that the stacked type junction does not function in good order.

In order to manufacture a point contact type junction, a Dayem bridge type junction and a variable thickness bridge type junction by using oxide superconductor, very fine processings which realize a weak link of a pair of superconductor are necessary. It is very difficult to conduct a fine processing with good repeatability.

The point contact type junction has been formed of two oxide superconductor thin films which are in contact with each other in a extremely small area which constitutes the weak link of the Josephson junction.

The Dayem bridge type junction has been formed of a constant thickness oxide superconductor thin film which is formed on a substrate and which is patterned in a plan view, so that a superconductor thin film region having a greatly narrow width is formed between a pair of superconductor thin film regions having a sufficient width. In other words, the pair of superconductor thin film regions having a sufficient width are coupled to each other by the superconductor thin film region having the greatly narrow width. Namely, a weak link of the Josephson junction in the superconductor thin film is formed at the greatly narrow width region.

On the other hand, the variable thickness bridge type junction has been formed of an oxide superconductor thin film of a sufficient thickness which is formed on a substrate and which is partially etched or thinned in a thickness direction, so that a thinned oxide superconductor thin film portion is formed between a pair of superconductor thin film portions having the sufficient thickness. In other words, the pair of superconductor thin film portions having the sufficient thickness are coupled to each other by the thinned oxide superconductor thin film portion. Accordingly, a weak link of the Josephson junction is formed at the reduced thickness portion of the oxide superconductor thin film.

As would be understood from the above, a characteristics of the Josephson device has a close relation to the contact area of the superconductor thin film in the point contact type Josephson device, the width of the superconductor thin film region having the extremely narrow width in the Dayem bridge type Josephson device, and to the thickness of the thinned oxide superconductor thin film portion in the variable thickness bridge type Josephson device, both of which form the weak link of the Josephson junction. Therefore, in order to obtain a desired characteristics with a good repeatability, a high precision on a sub-micron level of the processing such as the etching is required.

The Dayem bridge type Josephson device can be said to be more preferable than the variable thickness bridge type Josephson device, since the Dayem bridge type Josephson device has a relatively planer surface, which is preferred in a integrated circuit. However, in order to form the weak link in the Dayem bridge type Josephson device, it is required to pattern an oxide superconductor thin film having the thickness on the order of 0.5 µm to 1.0 µm into a width of not greater than 0,2 µm. However, it is very difficult to conduct this fine patterning with good repeatability.

On the other hand, in the variable thickness bridge type Josephson device, the very fine pattering is not required in order to form the weak link. However, it is very difficult to uniformly control the remaining thickness of the thinned portion forming the weak link. In addition, the variable thickness bridge type Josephson device cannot have a planer surface by nature. This is not preferable to the integrated circuit application.

Therefore, in the prior art, it is almost impossible to manufacture a superconducting device which has multiple homogeneous Josephson junctions by using an oxide superconductor.

In order to resolve the above mentioned problems, so-called step type Josephson junction device is proposed in a prior art, e.g. in Applied Physics Letters, vol. 59, no. 6, 5 August 1991, pages 733-735; K. CHAR et al.: "Bi-epitaxial grain boundary junctions in YBa₂Cu₃O₇. A Josephson junction device of this type comprises a substrate which includes a step on a principal surface and an oxide superconductor thin film formed on the principal surface of the substrate. The oxide superconductor thin film has a grain boundary at the step portion so that the oxide superconductor thin film separated two parts above and below the step which is linked weakly by the grain boundary. Each of the parts constitutes a superconducting electrode and the grain boundary constitutes a weak link of a Josephson junction. Thus, the above oxide superconductor thin film constitute a Josephson junction device.

No fine processing which is required to manufacture a point contact type Josephson junction device, a Dayem bridge type Josephson junction device or a variable thickness bridge type Josephson junction device is necessary to manufacture the step type Josephson junction device. However, crystalline directions of the two parts of the oxide superconductor thin film sometimes somes different from each other so that too large interfacial energy and unnecessary electrical resistance are generated at the step portion, which spoil the characteristics of the Josephson junction. This difference of the crystalline directions is considered to be caused by deformation of crystalline lattices of an etched surface of the substrate.

### Summary of the Invention

Accordingly, it is an object of the present invention to provide a step type Josephson junction device composed of an oxide superconductor material, which have overcome the above mentioned defects of the conventional ones, and a method for manufacturing a Josephson junction device with good repeatability by using already established processing techniques.

According to the present invention, there is provided a Josephson junction device comprising a single crystalline substrate including a principal surface, an oxide layer formed on the principal surface of the substrate having a step on its upper surface, oxide superconductor thin films and oxide thin films of the same thickness alternately formed on the upper surface of the oxide layer, in which each oxide superconductor thin film includes a step, with a first and a second portions of said oxide superconductor thin film respectively positioned above and below the step, said first and second portions of said oxide superconductor thin film are constituted of single crystals of the oxide superconductor having an identical crystal orientation, and a grain boundary on the step of the oxide layer, which constitutes a weak link of the Josephson junction.

It is preferable that the height of the step of the oxide layer is the same as the thickness of the oxide superconductor thin film and oxide thin film. In this case, the adjoining oxide superconductor thin films can constitute Josephson junctions.

The oxide thin film is preferably formed of Pr₁Ba₂Cu₃O_{7-y} oxide, because of the same reasons as mentioned above.

In a preferred embodiment, the oxide superconductor is formed of high-T_{c} (high critical temperature) oxide superconductor, particularly, formed of a high-T_{c} copper-oxide type compound oxide superconductor for example a Y-Ba-Cu-O compound oxide superconductor material, a Bi-Sr-Ca-Cu-O compound oxide superconductor material, and a Tl-Ba-Ca-Cu-O compound oxide superconductor material.

According to the present invention, there is also provided a method for manufacturing a Josephson junction device comprising the steps of forming an oxide layer on a principal surface of the single crystalline substrate, etching a portion of the oxide layer so that a step is formed on the surface of the oxide layer, forming an oxide superconductor thin film on the surface of the oxide layer and an oxide thin film having the same thickness as that of the oxide superconductor thin film on the oxide superconductor thin film and repeating forming oxide superconductor thin films and oxide thin films so that the oxide superconductor thin films and oxide thin films are stacked alternately and each of the oxide superconductor thin films includes a first and a second portions respectively positioned above and below the step of the oxide layer, which are constituted of single crystals of the oxide superconductor, and a grain boundary between pair of the upper and lower portions, which constitutes a weak link of the Josephson junction.

In one preferred embodiment, the step of the oxide layer is formed so as to have the same height as the thickness of the oxide superconductor thin films and oxide thin films.

The objects, features and advantages of the present invention will be apparent from the following description of preferred embodiments of the invention with reference to the accompanying drawings.

### Brief Description of the Drawings

Figures 1A to 1D are diagrammatic views for illustrating a process for manufacturing a step Josephson junction device;
Figures 2A to 2G are diagrammatic views for illustrating an embodiment of the process for manufacturing the Josephson junction device in accordance with the present invention.

### Description of the Preferred embodiments

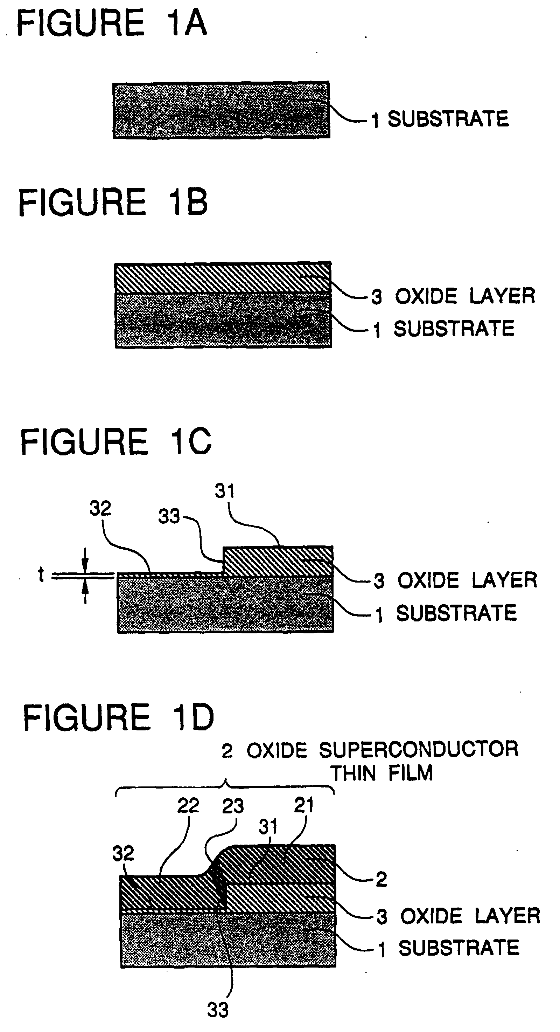

Referring to Figures 1A to 1D, a process for manufacturing a step Josephson device will be described.

As shown in Figure 1A, an MgO (100) single crystalline substrate 1 having a substantially planar principal surface ((100) surface) was prepared. In this embodiment, the MgO substrate had a size of 15 mm × 8 mm and a thickness of 0.5 mm. The MgO substrate 1 was heated to a temperature of 1100 °C under O₂ atmosphere for 8 hours in order to clean its surface. This heat-treatment was not necessary, if the surface of the MgO substrate 1 was clean enough.

Then, as shown in Figure 1B, a Pr₁Ba₂Cu₃O_{7-y} oxide layer 3 having a thickness of 200 nanometers was formed on the MgO substrate 1 by a sputtering. The conditions of the sputtering process were as follows;
- Temperature of substrate: 750°C
- Sputtering gases: Ar 9 sccm
O₂ 1 sccm
- Pressure: 6.665 Pa (5 × 10⁻² Torr)

The Pr₁Ba₂Cu₃O_{7-y} oxide layer 3 can also be formed by an MBE (molecular beam epitaxy), a vacuum evaporation, a laser ablation, etc.

Thereafter, as shown in Figure 1C, a portion 32 of the Pr₁Ba₂Cu₃O_{7-y} oxide layer 3 was etched by an ion milling using Ar ions so as to form a step 33. The step 33 had a height of 150 nanometers. The Pr₁Ba₂Cu₃O_{7-y} oxide layer 3 can be etched by a reactive ion etching or wet etching. In this connection, the etched portion 32 of the Pr₁Ba₂Cu₃O_{7-y} oxide layer 3 should have a thickness t thicker than 10 nanometers. After the etching, the substrate 1 was heated up to 350 to 400 °C under a pressure lower than 1.333 × 10⁻⁷ Pa (1 × 10⁻⁹ Torr) to clean up the surface of the Pr₁Ba₂Cu₃O_{7-y} oxide layer 3. This heat-treatment was not necessary, if the surface of the Pr₁Ba₂Cu₃O_{7-y} oxide layer 3 was clean enough.

Thereafter, as shown in Figure 1D, a Y₁Ba₂Cu₃O₇₋ₓ oxide superconductor thin film 2 having a thickness of 200 nanometers was deposited over the Pr₁Ba₂Cu₃O_{7-y} oxide layer 3 by a sputtering process. The conditions of the sputtering process were as follows;
- Temperature of substrate: 700°C
- Sputtering gas: Ar 9 sccm
O₂ 1 sccm
- Pressure: 6.665 Pa (5 × 10⁻² Torr)

The Y₁Ba₂Cu₃O₇₋ₓ oxide superconductor thin film 2 can be formed by an MBE (molecular beam epitaxy), a vacuum evaporation, a laser ablation, etc.

The Y₁Ba₂Cu₃O₇₋ₓ oxide superconductor thin film 2 had a grain boundary 23 on the step 33 of the Pr₁Ba₂Cu₃O_{7-y} oxide layer 3, which constituted a weak link of a Josephson junction. Two parts 21 and 22 of oxide superconductor thin film 2 which are positioned on a portion 31 and an etched portion 32 of Pr₁Ba₂Cu₃O_{7-y} oxide layer 3 constituted superconducting electrodes which were linked weakly by the grain boundary. The two parts 21 and 22 of oxide superconductor thin film 2 were formed of single crystalline Y₁Ba₂Cu₃O₇₋ₓ oxide superconductor of which crystalline directions were the same as each other.

The Y₁Ba₂Cu₃O₇₋ₓ oxide superconductor thin film 2 could be etched so as to form the narrow portion between portions 21 and 22, the center of which the grain boundary 23 crossed. Metal electrodes might be formed on the portions 21 and 22, if necessary. With this, a step Josephson junction device was completed.

A current-voltage characteristics of the above mentioned Josephson junction device was measured at a temperature of 85K. When a microwave was irradiated, clear Shapiro steps were observed, and therefore, it could be ascertained that the Josephson junction was realized in the device.

As explained above, the step Josephson junction device is composed of two superconducting electrodes of single-crystalline oxide superconductor, which grow at the same time and form a sheet of the oxide superconductor thin film and which have the same crystalline direction as each other, and a weak link of a grain boundary between them. The weak link of the Josephson junction device is formed of a self-generated grain boundary. Accordingly, the limitation in the fine processing technique required for manufacturing the Josephson junction device is relaxed.

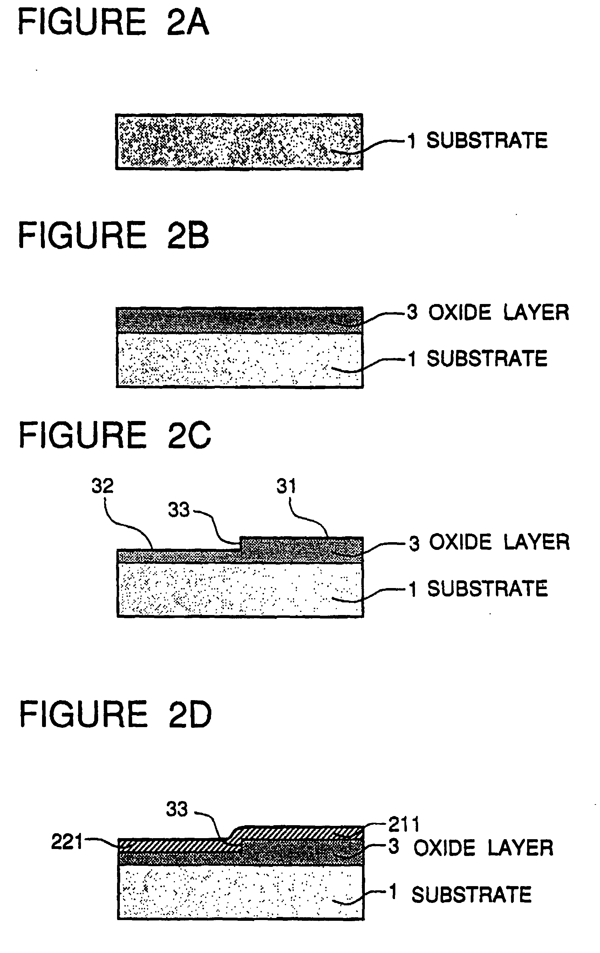

Referring to Figures 2A to 2G, an embodiment of the process for manufacturing the Josephson junction device according to the present invention will be described.

As shown in Figure 2A, an MgO (100) substrate 1 having a size of 15 mm × 8 mm and a thickness of 0.5 mm, similar to that of Embodiment 1 was prepared. As shown in Figure 2B, a Pr₁Ba₂Cu₃O₂C_{7-y} having a thickness 50 nanometers, was formed on the substrate 1 by an MBE process. The conditions of the MBE process were as follows;
- Temperature of substrate: 750°C
- Oxidation gas: O₃ 8 %
O₂ 92 %
- Pressure: 1.333 × 10⁻³ Pa (1 × 10⁻⁵ Torr)

Thereafter, as shown in Figure 2C, a portion 32 of the Pr₁Ba₂Cu₃O_{7-y} oxide layer 3 was etched by an ion milling using Ar ions so as to form a step 33. The step 33 had a height of 25 nanometers. The height of the step 33 was substantially same as the thickness of oxide superconductor thin films and oxide thin films which would be formed on the Pr₁Ba₂Cu₃O_{7-y} oxide layer 3. The Pr₁Ba₂Cu₃O_{7-y} oxide layer 3 can be etched by a reactive ion etching or wet etching. The etched portion 32 of the Pr₁Ba₂Cu₃O_{7-y} oxide layer 3 had a thickness of on the order of 20 nanometers.

Then, as shown in Figure 2D, a first Y₁Ba₂Cu₃O_{7-y} oxide superconductor thin film 211 having a thickness of 25 nanometers was deposited over the Pr₁Ba₂Cu₃O_{7-y} oxide layer 3 by an MBE process. The conditions of the MBE process were as follows;
- Temperature of substrate: 700°C
- Oxidation gas: O₃ 8 %
O₂ 92 %
- Pressure: 1.333 × 10⁻³ Pa (1 × 10⁻⁵ Torr)

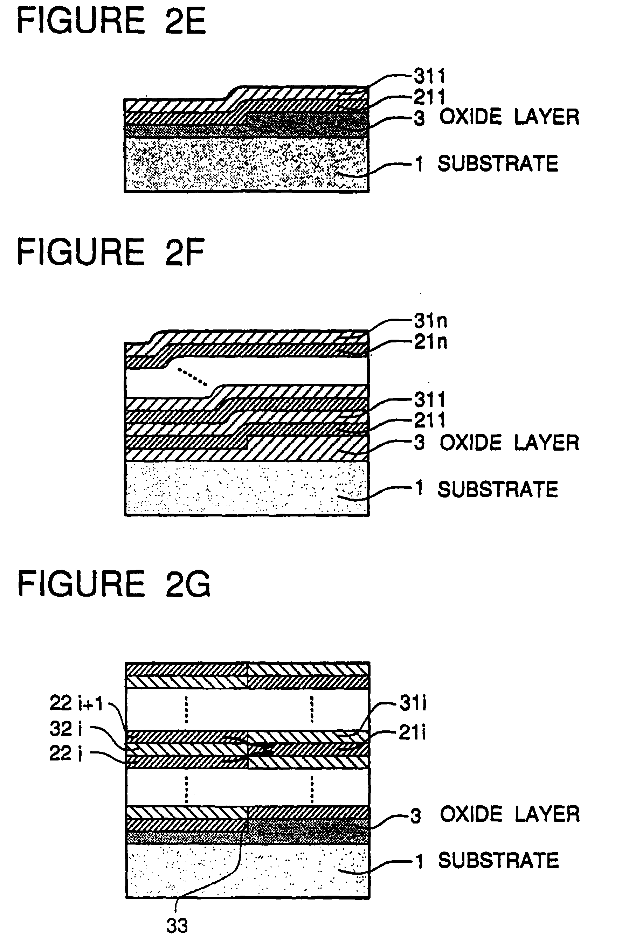

Then, the Y molecular beam source was exchanged to a Pr molecular beam source so that a first oxide thin film 311 composed of Pr₁Ba₂Cu₃O_{7-y} oxide having a thickness of about 25 nanometer was continuously formed on the Y₁Ba₂Cu₃O₇₋ₓ oxide superconductor thin film 211, as shown in Figure 2E. The conditions of the MBE process were as follows;
- Temperature of substrate: 700°C
- Oxidation gas: O₃ 8 %
O₂ 92 %
- Pressure: 1.333 × 10⁻³ Pa (1 × 10⁻⁵ Torr)

Thereafter, the Pr molecular beam source was exchanged to a Y molecular beam source so that a second Y₁Ba₂Cu₃O₇₋ₓ oxide superconductor thin film was continuously formed on the first Pr₁Ba₂Cu₃O_{7-y} oxide thin film 311.

The above operation was repeated so that n layers of Y₁Ba₂Cu₃O₇₋ₓ oxide superconductor thin films 211 to 21n and n layers of Pr₁Ba₂Cu₃O_{7-y} oxide thin films 311 to 31n were stacked alternately on one another, as shown in Figure 2F. The Pr₁Ba₂Cu₃O_{7-y} oxide thin film 31n which was formed at the top was a protection. In this embodiment, 10 Y₁Ba₂Cu₃O₇₋ₓ oxide superconductor thin films and Pr₁Ba₂Cu₃O_{7-y} oxide thin films were stacked. Metal electrodes might be formed on the Y₁Ba₂Cu₃O₇₋ₓ oxide superconductor thin film 21n and 22n, if necessary. With this, the Josephson junction device in accordance with the present invention was completed.

In above Josephson junction device, each Y₁Ba₂Cu₃O₇₋ₓ, oxide superconductor thin film has a grain boundary at its step portion which constitutes a Josephson junction. These Josephson junctions are constituted of self-generated grain boundaries so that they have substantially the same characteristics each other. Therefore, the Josephson junction device has integrated multiple homogeneous Josephson junction.

In addition, the adjoining Y₁Ba₂Cu₃O₇₋ₓ oxide superconductor thin films also constitutes Josephson junctions. Referring to Figure 2G, this will be described. Figure 2G shows an equivalent structure of the Josephson junction device shown in Figure 2F. As shown in Figure 2G, the Josephson junction device is considered to be constituted of Y₁Ba₂Cu₃O₇₋ₓ oxide superconductor thin films and Pr₁Ba₂Cu₃O_{7-y} oxide thin films which are arranged in rows in staggered fashion. In the Josephson junction device, Y₁Ba₂Cu₃O₇₋ₓ oxide superconductor thin film 21i constitutes one Josephson junction with Y₁Ba₂Cu₃O₇₋ₓ oxide superconductor thin film 22i and another with Y₁Ba₂Cu₃O₇₋ₓ oxide superconductor thin film 22i+1. The oxide superconductor thin film 22i has a weak link with the oxide superconductor thin film 21i, because they are grown at the same time to form a step junction. However, the oxide superconductor thin film 21i has the same relation with the oxide superconductor thin film 22i+1 as the the oxide superconductor thin film 22i, since the oxide thin films 31i and 32i are extremely thin at the step portions. Therefore, the oxide superconductor thin films 22i+1 and 21i can directly contact each other through weak link portion. Utilizing an MBE method, it is possible conduct this sharp edge thin film deposition.

A current-voltage characteristics of the above mentioned Josephson junction device was measured at a temperature of 85K. When a microwave was irradiated, clear Shapiro steps were observed, and therefore, it could be ascertained that the Josephson junction was realized in the device.

As explained above, the Josephson junction device manufactured in accordance with the method of the present invention includes multiple homogeneous Josephson junction. The weak links of the Josephson junction device are formed of a self-generated grain boundaries. Accordingly, the limitation in the fine processing technique required for manufacturing the Josephson junction device is relaxed.

In addition, in the Josephson junction device, the adjoining oxide superconductor thin films also constitutes Josephson junctions. Therefore, the number of Josephson junctions of the Josephson junction device is almost twice as much as that of the oxide superconductor thin films. Thus, the Josephson junction device has a large current capability.

In the above mentioned embodiment, the oxide superconductor thin film can be formed of not only the Y-Ba-Cu-O compound oxide superconductor material, but also a high-T_{c} (high critical temperature) oxide superconductor material, particularly a high-T_{c} copper-oxide type compound oxide superconductor material, for example a Bi-Sr-Ca-Cu-O compound oxide superconductor material, and a Tl-Ba-Ca-Cu-O compound oxide superconductor material.

The invention has thus been shown and described with reference to the specific embodiments. However, it should be noted that the present invention is in no way limited to the details of the illustrated structures but converts and modifications may be made within the scope of the appended claims.

## Claims

1. A Josephson junction device comprising a single crystalline substrate (1) including a principal surface, an oxide layer (3) formed on the principal surface of the substrate having a step (33) on its upper surface, oxide superconductor thin films (211-21n) and oxide thin films (311-31n) altemately formed on the upper surface of the oxide layer, in which a thickness of each of said oxide superconductor thin films and of each of said oxide thin films is the same, each oxide superconductor thin film includes a step, with a first and a second portion (211-21n, 221-22n) of said oxide superconductor thin film respectively positioned above and below the step, said first and a second portion (211-21n, 221-22n) of said oxide superconductor thin film are constituted of single crystals of the oxide superconductor having an identical crystal orientation, and a grain boundary on the step of the oxide layer, which constitutes a weak link of the Josephson junction.

2. A Josephson junction device claimed in Claim 1 **characterized in that** a height of the step of the oxide layer is the same as the thickness of the oxide superconductor thin film and oxide thin film.

3. A Josephson junction device claimed in Claim 1 or 2 **characterized in that** the oxide thin film is formed of Pr₁Ba₂Cu₃O_{7-y} oxide.

4. A Josephson junction device claimed in anyone of Claims 1 to 3 **characterized in that** the oxide superconductor thin film is formed of a high-T_{c} (high critical temperature) oxide superconductor.

5. A Josephson junction device claimed in Claim 4 **characterized in that** the oxide superconductor thin film is formed of a high-T_{c} copper-oxide type compound oxide superconductor..

6. A Josephson junction device claimed in Claim 5 **characterized in that** the oxide superconductor thin film is formed of an oxide superconductor material selected from the group consisting of a Y-Ba-Cu-O type compound oxide superconductor material, a Bi-Sr-Ca-Cu-O type compound oxide superconductor material, and a Tl-Ba-Ca-Cu-O type compound oxide superconductor material.

7. A method for manufacturing a Josephson junction device comprising the steps of forming an oxide layer on a principal surface of the single crystalline substrate, etching a portion of the oxide layer so that a step is formed on the surface of the oxide layer, forming an oxide superconductor thin film on the surface of the oxide layer and an oxide thin film having the same thickness as that of the oxide superconductor thin film on the oxide superconductor thin film and repeating forming oxide superconductor thin films and oxide thin films so that the oxide superconductor thin films and oxide thin films are stacked alternately and each of the oxide superconductor thin films includes a first and a second portions respectively positioned above and below the step of the oxide layer, which are constituted of single crystals of the oxide superconductor, and a grain boundary between every pair of said upper and lower portions, which constitutes a weak link of the Josephson junction.

8. A method claimed in Claim 7 **characterized in that** the step of the oxide layer is formed so as to have the same height as a thickness of the oxide superconductor thin films and oxide thin films.

## Patentansprüche

1. Vorrichtung mit einem Josephson-Übergang, die ein Einkristall-Substrat (1) mit einer Hauptoberfläche aufweist, wobei eine Oxidschicht (3) auf der Hauptoberfläche des Substrats mit einer Stufe (33) auf ihrer Oberfläche ausgebildet ist und wobei oxidische supraleitende Dünnschichten (211-21n) und oxidische Dünnschichten (311-31n) abwechselnd auf der Oberfläche der Oxidschicht angeordnet sind, mit gleichen Dicken der oxidischen supraleitenden Dünnschichten und der oxidischen Dünnschichten und wobei jede oxidische supraleitende Dünnschicht eine Stufe aufweist, derart, daß erste und zweite Abschnitte (211-21n, 221-22n) der oxidischen supraleitenden Dünnschicht oberhalb bzw. unterhalb der Stufe angeordnet sind und wobei die ersten und zweiten Abschnitte (211-21n, 221-22n) der oxidischen supraleitenden Dünnschicht aus Einkristallen eines oxidischen Supraleiters bestehen mit identischer Kristallorientierung und wobei eine Korngrenze in der Stufe aus der Oxidschicht den schwachen Übergang des Josephson-Übergangs bildet.

2. Vorrichtung mit Josephson-Übergang nach Anspruch 1, dadurch gekennzeichnet, daß die Höhe der Stufe der oxidischen Schicht gleich der Dicke der oxidischen supraleitenden Dünnschicht und der oxidischen Dünnschicht ist.

3. Vorrichtung mit Josephson-Übergang nach Anspruch 1 oder 2, dadurch gekennzeichnet, daß die oxidische Dünnschicht aus einem Pr₁Ba₂Cu₃O_{7-y}-Oxid besteht.

4. Vorrichtung mit Josephson-Übergang nach einem der Ansprüche 1 bis 3, dadurch gekennzeichnet, daß die oxidische supraleitende Dünnschicht aus einem oxidischen Supraleiter mit hoher Tc (hoher kritischer Temperatur) besteht.

5. Vorrichtung mit Josephson-Übergang nach Anspruch 4, dadurch gekennzeichnet, daß die oxidische supraleitende Dünnschicht aus einem supraleitenden Kupfer-Verbundoxid mit hoher Tc besteht.

6. Vorrichtung mit Josephson-Übergang nach Anspruch 5, dadurch gekennzeichnet, daß die oxidische supraleitende Dünnschicht aus einem supraleitenden Material besteht, das ausgewählt ist aus der Gruppe bestehend aus einem supraleitenden Y-Ba-Cu-O-Verbundoxid, einem supraleitenden Bi-Sr-Ca-Cu-O-Verbundoxid und einem supraleitenden Tl-Ba-Ca-Cu-O-Verbundoxid.

7. Verfahren zur Herstellung einer Vorrichtung mit Josephson-Übergang umfassend die Schritte des Ausbildens einer Oxidschicht auf einer Hauptoberfläche eines Einkristall-Substrats, des Ätzens eines Abschnitts der Oxidschicht, um so eine Stufe auf der Oberfläche der Oxidschicht auszubilden, des Ausbildens einer oxidischen supraleitenden Dünnschicht auf der Oberfläche der Oxidschicht und einer oxidischen Dünnschicht, deren Dicke gleich derjenigen der oxidischen supraleitenden Dünnschicht auf der oxidischen supraleitenden Dünnschicht ist und des wiederholten Ausbildens von oxidischen supraleitenden Dünnschichten und oxidischen Dünnschichten derart, daß die oxidischen supraleitenden Dünnschichten und die oxidischen Dünnschichten abwechselnd übereinander angeordnet sind und jede der oxidischen supraleitenden Dünnschichten einen ersten und einen zweiten Abschnitt aufweisen, die oberhalb bzw. unterhalb der Stufe in der Oxidschicht angeordnet sind, die aus Einkristallen der oxidischen Supraleiter bestehen, wobei eine Korngrenze zwischen jedem Paar oberer und unterer Abschnitte besteht, welche den schwachen Übergang des Josephson-Übergangs bildet.

8. Verfahren nach Anspruch 7, dadurch gekennzeichnet, daß die Stufe in der Oxidschicht derart ausgebildet ist, daß ihre Dicke gleich denjenigen der oxidischen supraleitenden Dünnschichten und der oxidischen Dünnschichten ist.

## Revendications

1. Dispositif à jonction Josephson comportant un substrat monocristallin (1) comprenant une surface principale , une couche d'oxyde (3) formée sur la surface principale du substrat présentant un gradin (33) sur sa surface supérieure, des films minces d'oxyde supraconducteur (211-21n) et des films minces d'oxyde (311-31n) formés en alternance sur la surface supérieure de la couche d'oxyde, dans lequel l'épaisseur de chacun desdits films minces d'oxyde supraconducteur et de chacun desdits films minces d'oxyde est la même , chaque film mince d'oxyde supraconducteur comporte un gradin, possédant une première et une seconde partie (211-21n, 221-22n) dudit film mince d'oxyde supraconducteur positionnée respectivement au-dessus et au-dessous du gradin, lesdites première et seconde parties (211-21n, 221-22n) dudit film mince d'oxyde supraconducteur sont constituées de monocristaux de l'oxyde supraconducteur présentant une orientation cristalline identique , et un joint de grain situé sur le gradin de la couche d'oxyde, lequel constitue une liaison faible de la jonction Josephson.

2. Dispositif à jonction Josephson selon la revendication 1, caractérisé en ce que la hauteur du gradin de la couche d'oxyde est égale à l'épaisseur du film mince d'oxyde supraconducteur et du film mince d'oxyde.

3. Dispositif à jonction Josephson selon la revendication 1 ou 2, caractérisé en ce que le film mince d'oxyde est formé d'oxyde de Pr₁Ba₂Cu₃O_{7-y}.

4. Dispositif à jonction Josephson selon l'une quelconque des revendications 1 à 3, caractérisé en ce que le film mince d'oxyde supraconducteur est formé d'un oxyde supraconducteur à T_{c} élevée (température critique élevée).

5. Dispositif à jonction Josephson selon la revendication 4, caractérisé en ce que le film mince d'oxyde supraconducteur est formé d'un supraconducteur d'oxyde composé de type oxyde de cuivre à T_{c} élevée .

6. Dispositif à jonction Josephson selon la revendication 5, caractérisé en ce que le film mince d'oxyde supraconducteur est formé d'un matériau d'oxyde supraconducteur sélectionné dans le groupe constitué d'un matériau supraconducteur d'oxyde composé de type Y-Ba-Cu-O, d'un matériau supraconducteur d'oxyde composé du type Bi-Sr-Ca-Cu-O et d'un matériau supraconducteur d'oxyde composé du type Tl-Ba-Ca-Cu-O.

7. Procédé de fabrication d'un dispositif à jonction Josephson comprenant les étapes consistant à former une couche d'oxyde sur une surface principale du substrat monocristallin, graver une partie de la couche d'oxyde de façon qu'un gradin soit formé sur la surface de la couche d'oxyde , former un film mince d'oxyde supraconducteur sur la surface de la couche d'oxyde et un film mince d'oxyde présentant la même épaisseur que celle du film mince d'oxyde supraconducteur et du film mince d'oxyde et répéter la formation des films minces d'oxyde supraconducteur et des films minces d'oxyde, de sorte que les films minces d'oxyde supraconducteur et les films minces d'oxyde soient empilés en alternance et que chacun des films minces d'oxyde supraconducteur comprenne des première et seconde parties, positionnées respectivement au-dessus et au-dessous du gradin de la couche d'oxyde, lesquelles sont constituées de monocristaux de l'oxyde supraconducteur , et un joint de grain entre chaque paire desdites parties supérieure et inférieure, ce qui constitue une liaison faible de la jonction Josephson.

8. Procédé selon la revendication 7 caractérisé en ce que le gradin de la couche d'oxyde est formé de façon à posséder la même hauteur que l'épaisseur des films minces d'oxyde supraconducteur et des films minces d'oxyde.
